# FASCICULE DE BREVET EUROPEEN

(11) **EP 3 220 212 B1**
(45) Date de publication et mention de la délivrance du brevet: **29.05.2024**
(21) Numéro de dépôt: 16160659.5
(22) Date de dépôt: 16.03.2016
(51) Int. Cl.: G04B 37/22, G04B 19/04, G04B 19/06, G04B 13/02, G04B 29/02, G04D 3/00, G04B 5/16

(54) **PROCÉDÉ DE DÉCORATION D'UN COMPOSANT HORLOGER**
DEKORATIONSVERFAHREN FÜR EINE UHRKOMPONENTE
METHOD FOR DECORATING A TIMEPIECE COMPONENT

(43) Date de publication de la demande: 20.09.2017
(73) Titulaire: The Swatch Group Research and Development Ltd, 2074 Marin (CH)
(72) Inventeur: Manasterski, Christian, 2019 Rochefort (CH); Faure, Cédric, 2016 Cortaillod (CH); Springer, Simon, 3007 Berne (CH); Rossier, Gérard, 2300 La Chaux-de-Fonds (CH)
(74) Mandataire: ICB SA

(56) Documents cités:
- EP-A1- 0 603 673
- EP-A1- 2 434 031
- CH-B1- 705 653
- US-A- 4 252 862
- US-A- 4 415 421
- US-A- 4 791 017
- US-A- 5 985 469
- US-A1- 2011 123 815

## Description

### Domaine de l'invention

L'invention concerne un procédé de décoration d'un composant horloger comprenant une étape de préparation du composant horloger, une étape de protection à la corrosion, et une étape de mise en couleur pour former une couche de décoration externe de couleur.

### Arrière-plan de l'invention

Un tel procédé est classiquement utilisé pour réaliser des composants horlogers, plus particulièrement des aiguilles et des appliques, et notamment des aiguilles et appliques en laiton.

Selon ce procédé, le composant horloger est préparé en déposant sur toutes les faces du composant horloger une première couche protectrice par voie galvanique. Cette technique présente l'avantage de pouvoir prétraiter de grandes quantités de composants à un rythme relativement élevé. Le composant subit ensuite une opération mécanique de diamantage qui permet, par la réalisation de facettes, de donner un aspect brillant et scintillant au composant. On traite ensuite le composant de nouveau par voie galvanique pour déposer sur toutes les faces du composant une couche de protection à la corrosion, ainsi qu'une couche de décoration externe de couleur. Ces opérations par voie galvanique sont cette fois complexes en raison des surfaces délicates obtenues après diamantage. De ce fait, la couleur de la couche de décoration externe peut parfois présenter des hétérogénéités, ce qui entraine la mise au rebut du composant. De plus, avec cette technique galvanique, les coûts de production sont élevés et il n'est pas possible de déposer tous les alliages pour obtenir toutes les couleurs possibles.

On connait également d'autres procédés de décoration sans diamantage, tels que ceux décrits dans le document EP 2 434 031, dans le document US 4 791 017, ou le document US 4252862.

Le document EP 2 434 031 décrit un procédé de décoration d'un article décoratif comprenant le dépôt par PVD d'une sous-couche rugueuse, par exemple en aluminium, sur un substrat puis le dépôt par PVD d'une couche réfléchissante, en or ou en argent, sur ladite sous-couche rugueuse, la couche réfléchissante suivant le profil de la sous-couche rugueuse. Le revêtement obtenu est blanc, mat ou légèrement brillant, la couleur blanche étant obtenue grâce à la topographie de surface du revêtement.

Le document US 4 791 017 décrit un procédé de réalisation d'un article décoré comprenant l'application sur un substrat d'une sous-couche de haute dureté et de coloration dorée à base de carbonitrure de titane, nitrure de zirconium, nitrure de hafnium, nitrure de vanadium et carbonitrure de vanadium, et un revêtement à base d'or. Cette sous-couche permet d'obtenir une sous-couche dure, présentant une brillance et une couleur comparables à celles du revêtement à base d'or.

Le document US 4 252 862 décrit un procédé d'ornement d'un composant horloger comportant une étape de dépôt d'une première sous-couche sur le composant horloger de manière à former une couche à base de nickel et de chrome ; la première sous-couche permettant de protéger le composant horloger contre la corrosion, une deuxième étape de dépôt d'un deuxième matériau sur le composant horloger pour former une deuxième sous-couche à base de TiN, de manière à avoir une deuxième sous-couche colorée (présentant une couleur jaunâtre) et dure au moyen d'un procédé de dépôt physique en phase vapeur (PVD) par faisceau d'électrons, et une troisième étape de mise en couleur comprenant le dépôt d'un troisième matériau (par exemple de l'or dans l'exemple 2) pour former une couche de décoration externe de couleur ; la couche de décoration externe étant déposée directement sur la deuxième sous-couche à base de TiN ; l'étape de mise en couleur étant réalisée au moyen d'un procédé PVD.

### Résumé de l'invention

L'invention a notamment pour objectif de pallier ces différents inconvénients.

Plus précisément, un objectif de l'invention est de proposer un procédé industriel de décoration de composants horlogers, simple à mettre en oeuvre et rationnalisé, afin de diminuer les coûts de production.

Un autre objectif de l'invention est de proposer un procédé industriel de décoration de composants horlogers permettant de réduire le taux de mise au rebut ou de déchets.

A cet effet, la présente invention concerne un procédé de décoration d'un composant horloger selon la revendication 1. Des modes particuliers de réalisation de la présente invention sont définis par les revendications dépendantes 2 à 16.

D'une manière avantageuse, la première étape de dépôt lors de l'étape de préparation a) peut également être réalisée par un procédé de dépôt physique en phase vapeur.

Selon un mode de réalisation préféré de l'invention, au moins la deuxième étape de dépôt b) et l'étape de mise en couleur c), et optionnellement la première étape de dépôt lors de l'étape de préparation a), sont réalisées sans rupture des conditions de vide.

Le procédé selon l'invention permet ainsi une rationalisation de la mise en oeuvre de ses différentes étapes. De plus, il permet d'obtenir une couche de décoration externe de couleur présentant une grande homogénéité, et de diminuer ainsi le taux de mise au rebut des composants horlogers.

### Description sommaire des dessins

D'autres caractéristiques et avantages de l'invention apparaîtront plus clairement à la lecture de la description suivante d'un mode de réalisation de l'invention, donné à titre de simple exemple illustratif et non limitatif, et des figures annexées, parmi lesquelles :

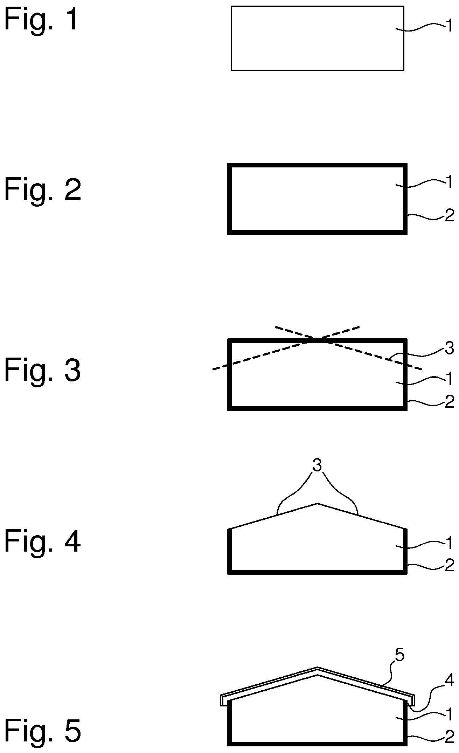

- les figures 1 à 5 représentent une vue en coupe d'un composant horloger traités selon les différentes étapes du procédé selon l'invention

### Description détaillée d'un mode de réalisation préféré

En référence à la figure 1, il est représenté une vue en coupe d'un composant horloger 1 brut, par exemple une aiguille, notamment une aiguille en laiton ou en bronze.

Le composant horloger peut par exemple être choisi parmi le groupe comprenant les aiguilles, les appliques, les cadrans, les réhauts, les lunettes, les couronnes, les poussoirs, les masses oscillantes, les roues, les ponts, les platines, ou tout autre élément ou organe utilisé dans une pièce d'horlogerie auquel on souhaite donner une couleur.

Le composant horloger 1 est tout d'abord préparé selon l'étape de préparation a) du procédé de l'invention. Cette étape de préparation peut comprendre par exemple, de manière optionnelle, une première étape de dépôt d'un premier matériau sur le composant horloger 1 pour former une première sous-couche 2 comme le montre la figure 2. De préférence, la première sous-couche 2 recouvre toutes les faces du composant horloger 1. Le dépôt de cette première sous-couche 2 peut être réalisé par voie galvanique d'une manière connue de l'homme du métier. Un dépôt PVD peut également être avantageusement utilisé, comme on le verra ci-après.

La première sous-couche 2 constitue notamment une sous-couche de protection qui est nécessaire lorsque l'étape de préparation a) comprend une étape de diamantage. Cette étape consiste à former sur la surface du composant horloger 1 qui sera visible depuis l'extérieur de la pièce d'horlogerie, des surfaces biseautées ou facettes 3 à l'aide d'un outil serti de diamants, comme le montre la figure 3. Ce traitement mécanique permet de donner un aspect brillant et scintillant au composant horloger 1. Après le diamantage, la première sous-couche 2 a été enlevée sur le dessus du composant horloger 1, comme le montre la figure 4. D'autres opérations similaires au diamatage peuvent aussi être possibles (satinage, soleillage, brossage ou avivage).

La première sous-couche 2 permet également de favoriser l'adhésion des autres couches à venir sur le composant horloger 1.

L'étape de préparation a) peut en outre comprendre une étape de nettoyage du composant horloger 1 obtenu après diamantage. D'une manière connue de l'homme du métier, l'étape de nettoyage peut être réalisée par exemple par dégraissage chimique, suivi de rinçages à l'eau de ville et à l'eau déminéralisée. Le composant horloger 1 est ensuite séché et est prêt pour la mise en oeuvre de la deuxième étape de dépôt b).

Ladite deuxième étape de dépôt b) comprend le dépôt d'un deuxième matériau sur le composant horloger 1 obtenu à l'étape de préparation a) pour former une deuxième sous-couche 4. Cette deuxième sous-couche 4 constitue notamment une deuxième sous-couche de protection à la corrosion. Elle permet également de favoriser l'adhésion de la couche de décoration 5 au composant horloger 1. La couleur de cette deuxième sous-couche 4 peut avantageusement être choisie proche de la couleur de la couche de décoration 5 afin d'éviter un contraste visible en cas d'usure de ladite couche de décoration 5.

Puis selon l'étape de mise en couleur c), un troisième matériau de couleur est déposé sur le composant horloger 1 obtenu à la deuxième étape de dépôt b) pour former une couche de décoration externe de couleur 5.

Conformément à l'invention, au moins la deuxième étape de dépôt b) et l'étape de mise en couleur c) sont réalisées par un procédé de dépôt physique en phase vapeur (Physical Vapor Deposition, PVD).

Les composants horlogers décorés selon le procédé de l'invention comprennent une couche de décoration externe 5 présentant une couleur particulièrement homogène, de sorte que le taux de déchet est très faible.

D'une manière particulièrement avantageuse, la deuxième sous-couche 4 ainsi que la couche de décoration 5 sont déposées seulement sur les surfaces diamantées 3 et sur les flancs du composant horloger. Il est toutefois possible de prévoir au cours l'étape de mise en couleur c) une étape de retournement ou l'utilisation d'une installation permettant un dépôt PVD sur les deux faces du composant horloger, si l'on souhaite que la deuxième sous-couche 4 et la couche de décoration 5 soient présentes également sur le dos du composant.

De préférence, la première étape de dépôt lors de l'étape a) est également réalisée par un procédé de dépôt physique en phase vapeur au lieu d'un dépôt galvanique.

Selon un mode de réalisation particulièrement préféré, le procédé de dépôt physique en phase vapeur peut être un procédé par pulvérisation cathodique (sputtering). Le gaz de pulvérisation est inerte, typiquement l'argon. Les paramètres de dépôt PVD sont déterminés par l'homme du métier afin de répondre aux critères de couleur et de qualité propres à la fonction et/ou au modèle sélectionné.

Le procédé selon l'invention peut également comprendre, avant la mise en oeuvre de la deuxième étape de dépôt b) une étape d'activation ionique. Les paramètres de l'activation ionique sont déterminés par l'homme du métier. L'activation ionique garantit la parfaite adhérence de la deuxième sous-couche 4 déposée directement sur les surfaces diamantées 3 du composant horloger 1 mises à nu lors de l'opération de diamantage.

D'une manière particulièrement préférée, au moins la deuxième étape de dépôt b) et l'étape de mise en couleur c), et optionnellement la première étape de dépôt lors de l'étape de préparation a), sont réalisées sans rupture des conditions de vide, dans la même installation, ce qui permet une mise en oeuvre industrielle simple et économique du procédé de l'invention.

D'une manière avantageuse, le premier matériau est choisi de sorte que la première sous-couche 2 protège le composant horloger 1 et/ou favorise l'adhésion de la deuxième sous-couche 4 et de la couche de décoration externe de couleur 5. De même, le deuxième matériau est choisi de sorte que la deuxième sous-couche 4 protège le composant horloger 1 de la corrosion et/ou favorise l'adhésion de la couche de décoration externe de couleur 5. De préférence, au moins le deuxième matériau est un matériau anticorrosif.

De préférence, le premier matériau et/ou le deuxième matériau peut être choisi parmi le groupe comprenant le nickel, le chrome, un acier inoxydable, l'étain, les métaux précieux, et leurs alliages (par exemple un alliage Cr/Ni (par exemple inconel), Sn/Ni ou Pd/Ni).

Le premier matériau et/ou le deuxième matériau peut comprendre du nickel, dans une quantité comprise entre 0% et 100% en poids.

En particulier, le premier matériau peut être du nickel.

Selon un autre mode de réalisation, le premier et/ou le deuxième matériau peut être un alliage de chrome et de nickel, comprenant du chrome dans une quantité comprise entre 20% et 80% en poids, et de préférence entre 30% et 70% en poids.

Dans le cas d'un procédé réalisé sans rupture des conditions de vide, le premier matériau est de préférence identique au deuxième matériau, ce qui permet de rationaliser davantage le procédé.

De préférence, la deuxième sous-couche 4 peut présenter une épaisseur comprise entre 200 nm et 1500 nm.

Plus généralement, la composition et l'épaisseur de la deuxième sous-couche 4 sont adaptées à la nature du matériau du composant horloger 1 et du troisième matériau.

D'une manière avantageuse, le troisième matériau de couleur peut être choisi parmi le groupe comprenant les métaux précieux et leurs alliages, ou des matériaux intrinsèquement stables dans le temps, comme l'aluminium, et leurs alliages, et des céramiques. La céramique peut être de couleur, telle que du nitrure de titane, ou transparente pour laisser apparaitre la couleur de la deuxième sous-couche.

Notamment, le troisième matériau de couleur peut être choisi parmi le groupe comprenant l'or, l'argent, le palladium, le platine, le rhodium et leurs alliages.

D'une manière particulièrement avantageuse, le troisième matériau de couleur est un alliage d'or 18K 5N, ou encore un alliage d'or 18.5K sans nickel et sans cobalt comprenant en poids entre 75% et 77,5% d'or, entre 1,2% et 1,6% de palladium et entre 20,1% et 23,8% de cuivre. Le brevet CH 705 653, dont le contenu est incorporé à la présente demande par référence, décrit un tel alliage massif comme présentant des caractéristiques de décoloration améliorée.

Cet alliage est particulièrement préféré pour l'application de la couche de décoration externe de couleur par la voie PVD car il permet d'obtenir une couche de décoration, qui en plus de présenter une couleur homogène et un titre constant par rapport au titre du troisième matériau, présente une résistance à la décoloration et au ternissement meilleure que celle d'une couche obtenue à partir d'un même alliage mais déposée par la voie galvanique. De plus, la résistance à la corrosion de la couche de décoration obtenue selon le procédé de l'invention est supérieure à celle de l'alliage massif.

De préférence, la couche de décoration externe de couleur 5 présente une épaisseur comprise entre 100 nm et 1500 nm.

Le procédé de l'invention permet d'obtenir une production industrielle de composants horlogers présentant une couche de décoration de couleur de haute qualité, déposée avec fiabilité et répétabilité. De plus, il permet d'utiliser de nombreux alliages présentant de nombreuses couleurs pour réaliser des couches de décoration de couleurs très variées.

L'exemple suivant illustre la présente invention sans toutefois en limiter la portée.

### Exemple :

Des aiguilles découpées dans du laiton sont revêtues d'une première sous-couche 2 de nickel par voie galvanique et sont diamantées. Puis il est procédé à un nettoyage lessiviel des aiguilles.

Les aiguilles ainsi préparées sont ensuite alignées sur le portesubstrat d'une machine PVD/sputtering du marché. Elles sont espacées de manière à permettre le passage du plasma.

On effectue alors le traitement PVD. Il n'y a pas de phase de chauffage afin de ne pas déformer les aiguilles.

Après activation ionique des aiguilles, on dépose sous argon la deuxième sous-couche 4 à base de nickel et de chrome puis la couche de décoration 5 en alliage d'or. L'alliage d'or est l'alliage 18.5K sans nickel et sans cobalt comprenant en poids entre 75% et 77,5% d'or, entre 1,2% et 1,6% de palladium et entre 20,1% et 23,8% de cuivre décrit dans le brevet CH 705 653. Les paramètres de dépôt PVD sont choisis de manière à déposer une deuxième sous-couche 4 à base de nickel et de chrome de 1 µm et une couche de décoration 5 en alliage d'or de 0.5 µm.

Les aiguilles traitées selon le procédé de l'invention présentent une couleur très homogène de sorte que le taux de déchet est régulièrement inférieur à 1%.

A titre comparatif, des aiguilles pour lesquelles la couche de décoration externe de couleur est à base du même alliage d'or 18.5K tel que décrit dans le brevet CH 705 653, sont traitées de manière similaire à l'invention mais selon un procédé dans lequel la deuxième étape de dépôt b) est réalisée par voie galvanique et l'étape de mise en couleur c) est réalisée par voie PVD. Ces aiguilles présentent typiquement un taux de déchet supérieur à 5%.

A titre comparatif également, des aiguilles pour lesquelles la couche de décoration externe de couleur est à base d'or 18 K 5N, et traitées de manière similaire à l'invention mais avec un procédé entièrement galvanique (y compris pour les étapes b) et c)), présentent un taux de déchet supérieur à 5%.

## Revendications

1. Procédé de décoration d'un composant horloger (1) comprenant :
a) une étape de préparation du composant horloger (1) comprenant une première étape de dépôt d'un premier matériau sur toutes les faces du composant horloger (1) pour former une première sous-couche (2) de protection et une étape de traitement mécanique du composant horloger (1) sur la surface du composant horloger (1) qui sera visible de l'extérieur,
b) une deuxième étape de dépôt d'un deuxième matériau anticorrosif par un procédé de dépôt physique en phase vapeur (Physical Vapor Deposition, PVD) pour former une deuxième sous-couche (4) de protection à la corrosion sur la surface traitée mécaniquement et sur les flancs du composant horloger (1) pour protéger contre la corrosion ledit composant horloger (1) obtenu à l'étape de préparation a),
c) une étape de mise en couleur comprenant le dépôt d'un troisième matériau de couleur sur la deuxième sous-couche (4) du composant horloger (1) obtenu à la deuxième étape de dépôt b) par un procédé de dépôt physique en phase vapeur (Physical Vapor Deposition, PVD), pour former une couche de décoration externe de couleur (5).

2. Procédé selon la revendication 1, **caractérisé en ce que** la première étape de dépôt lors de l'étape de préparation a) est réalisée par un procédé de dépôt physique en phase vapeur.

3. Procédé selon la revendication1 ou 2, **caractérisé en ce que** le premier matériau est choisi de sorte que la première sous-couche (2) favorise l'adhésion de la deuxième sous-couche (4) et de la couche de décoration externe de couleur (5).

4. Procédé selon l'une des revendications précédentes, **caractérisé en ce que** le deuxième matériau est choisi de sorte que la couleur de la deuxième sous-couche (4) est proche de la couleur de la couche de décoration externe de couleur (5).

5. Procédé selon l'une des revendications précédentes, **caractérisé en ce que** le premier matériau est choisi parmi le groupe comprenant le nickel, le chrome, un acier inoxydable, l'étain, les métaux précieux, et leurs alliages.

6. Procédé selon l'une des revendications précédentes, **caractérisé en ce que** le deuxième matériau est un alliage de nickel et de chrome.

7. Procédé selon l'une des revendications 5 et 6, **caractérisé en ce que** le premier matériau et/ou le deuxième matériau est un alliage de nickel et de chrome, la quantité de chrome étant comprise entre 20% et 80% en poids, et de préférence entre 30% et 70% en poids.

8. Procédé selon l'une des revendications précédentes, **caractérisé en ce que** la deuxième sous-couche (4) présente une épaisseur comprise entre 200 nm et 1500 nm.

9. Procédé selon l'une des revendications précédentes, **caractérisé en ce que** le troisième matériau de couleur est choisi parmi le groupe comprenant les métaux précieux et leurs alliages, l'aluminium et ses alliages, et des céramiques.

10. Procédé selon la revendication 9, **caractérisé en ce que** le troisième matériau de couleur est choisi parmi le groupe comprenant l'or, l'argent, le palladium, le platine, le rhodium et leurs alliages.

11. Procédé selon la revendication 10, **caractérisé en ce que** le troisième matériau de couleur est un alliage d'or sans nickel et sans cobalt comprenant en poids entre 75% et 77,5% d'or, entre 1,2% et 1,6% de palladium et entre 20,1% et 23,8% de cuivre.

12. Procédé selon l'une des revendications précédentes, **caractérisé en ce que** la couche de décoration externe de couleur (5) présente une épaisseur comprise entre 100 nm et 1500 nm.

13. Procédé selon l'une des revendications précédentes, **caractérisé en ce que** le procédé de dépôt physique en phase vapeur est un procédé par pulvérisation cathodique.

14. Procédé selon l'une des revendications précédentes, **caractérisé en ce que** l'étape de traitement mécanique du composant horloger (1) de_l'étape de préparation a) est une étape de diamantage.

15. Procédé selon l'une des revendications précédentes, **caractérisé en ce que** au moins la deuxième étape de dépôt b) et l'étape de mise en couleur c), et la première étape de dépôt lors de l'étape de préparation a), sont réalisées sans rupture des conditions de vide.

16. Procédé selon l'une des revendications précédentes, **caractérisé en ce que** le composant horloger (1) est choisi parmi le groupe comprenant les aiguilles, les appliques, les cadrans, les réhauts, les lunettes, les couronnes, les poussoirs, les masses oscillantes, les roues, les platines et les ponts.

## Patentansprüche

1. Verfahren zum Verzieren einer Uhrkomponente (1), umfassend:
a) einen Schritt des Vorbereitens der Uhrkomponente (1), der einen ersten Schritt des Aufbringens eines ersten Materials auf alle Flächen der Uhrkomponente (1), um eine erste Schutzunterschicht (2) zu bilden, und einen Schritt des mechanischen Bearbeitens der Uhrkomponente (1) auf der Oberfläche der Uhrkomponente (1), die von außen sichtbar sein wird, umfasst,
b) einen zweiten Schritt des Abscheidens eines zweiten korrosionsbeständigen Materials durch ein physikalisches Gasphasenabscheidungsverfahren (Physical Vapor Deposition, PVD), um eine zweite Schutzunterschicht (4) gegen Korrosion auf der mechanisch bearbeiteten Oberfläche und auf den Flanken der Uhrkomponente (1) zu bilden, um die im Vorbereitungsschritt a) erhaltene Uhrkomponente (1) vor Korrosion zu schützen,
c) einen Schritt des Färbens, der das Abscheiden eines dritten farbigen Materials auf der im zweiten Abscheidungsschritt b) durch ein physikalisches Gasphasenabscheidungsverfahren (Physical Vapor Deposition, PVD) erhaltenen zweiten Unterschicht (4) der Uhrkomponente (1) umfasst, um eine farbige äußere Verzierungsschicht (5) zu bilden.

2. Verfahren nach Anspruch 1, **dadurch gekennzeichnet, dass** der erste Abscheidungsschritt im Vorbereitungsschritt a) durch ein physikalisches Gasphasenabscheidungsverfahren durchgeführt wird.

3. Verfahren nach Anspruch 1 oder 2, **dadurch gekennzeichnet, dass** das erste Material derart gewählt wird, dass die erste Unterschicht (2) die Haftung der zweiten Unterschicht (4) und der farbigen äußeren Verzierungsschicht (5) ermöglicht.

4. Verfahren nach einem der vorhergehenden Ansprüche, **dadurch gekennzeichnet, dass** das zweite Material derart gewählt wird, dass die Farbe der zweiten Unterschicht (4) der Farbe der farbigen äußeren Verzierungsschicht (5) nahe kommt.

5. Verfahren nach einem der vorhergehenden Ansprüche, **dadurch gekennzeichnet, dass** das erste Material aus der Gruppe ausgewählt wird, die Nickel, Chrom, Edelstahl, Zinn, Edelmetalle und Legierungen davon umfasst.

6. Verfahren nach einem der vorhergehenden Ansprüche, **dadurch gekennzeichnet, dass** das zweite Material eine Legierung aus Nickel und Chrom ist.

7. Verfahren nach einem der Ansprüche 5 und 6, **dadurch gekennzeichnet, dass** das erste Material und/oder das zweite Material eine Legierung aus Nickel und Chrom ist, wobei die Chrommenge zwischen 20 Gew.-% und 80 Gew.-% und vorzugsweise zwischen 30 Gew.-% und 70 Gew.-% beträgt.

8. Verfahren nach einem der vorhergehenden Ansprüche, **dadurch gekennzeichnet, dass** die zweite Unterschicht (4) eine Dicke zwischen 200 nm und 1500 mm aufweist.

9. Verfahren nach einem der vorhergehenden Ansprüche, **dadurch gekennzeichnet, dass** das dritte farbige Material aus der Gruppe ausgewählt wird, die Edelmetalle und Legierungen davon, Aluminium und Legierungen davon sowie Keramik umfasst.

10. Verfahren nach Anspruch 9, **dadurch gekennzeichnet, dass** das dritte gefärbte Material aus der Gruppe ausgewählt wird, die Gold, Silber, Palladium, Platin, Rhodium und Legierungen davon umfasst.

11. Verfahren nach Anspruch 10, **dadurch gekennzeichnet, dass** das dritte gefärbte Material eine nickelfreie und kobaltfreie Goldlegierung ist, die zwischen 75 Gew.-% und 77,5 Gew.-% Gold, zwischen 1,2 Gew.-% und 1,6 Gew.-% Palladium und zwischen 20,1 Gew.-% und 23,8 Gew.-% Kupfer umfasst.

12. Verfahren nach einem der vorhergehenden Ansprüche, **dadurch gekennzeichnet, dass** die farbige äußere Verzierungsschicht (5) eine Dicke zwischen 100 nm und 1500 nm aufweist.

13. Verfahren nach einem der vorhergehenden Ansprüche, **dadurch gekennzeichnet, dass** das physikalische Dampfabscheidungsverfahren ein kathodisches Sputterverfahren ist.

14. Verfahren nach einem der vorhergehenden Ansprüche, **dadurch gekennzeichnet, dass** der mechanische Bearbeitungsschritt der Uhrkomponente (1) des Vorbereitungsschritts a) einen Feinschliffschritt umfasst.

15. Verfahren nach einem der vorhergehenden Ansprüche, **dadurch gekennzeichnet, dass** mindestens der zweite Abscheidungsschritt b) und der Färbeschritt c) und der erste Abscheidungsschritt im Vorbereitungsschritt a) ohne Unterbrechung der Vakuumbedingungen durchgeführt werden.

16. Verfahren nach einem der vorhergehenden Ansprüche, **dadurch gekennzeichnet, dass** die Uhrkomponente (1) aus der Gruppe ausgewählt wird, die Zeiger, Appliken, Zifferblätter, Höhenringe, Lünetten, Kronen, Drücker, Schwungmassen, Räder, Platinen und Brücken umfasst.

## Claims

1. Method for decorating a timepiece component (1) comprising:
a) a step of preparation of the timepiece component (1) comprising a first step of depositing a first material on all the faces of the timepiece component (1) to form a first protective sub-layer (2) and a step of mechanical treatment of the timepiece component (1) on the surface of the timepiece component (1) which will be visible from the outside,
b) a second step of depositing a second anti-corrosive material by a physical vapour deposition method (PVD) to form a second corrosion protection sub-layer (4) on the mechanically treated surface and on the flanks of the timepiece component (1) to protect said timepiece component (1) obtained in the preparation step a) against corrosion,
c) a colouring step comprising the deposition of a third coloured material on the second sub-layer (4) of the timepiece component (1) obtained in the second deposition step b) by a physical vapour deposition method (PVD) to form a coloured external decorative layer (5),

2. Method according to claim 1, **characterised in that** the first deposition step in the preparation step a) is achieved by a physical vapour deposition method.

3. Method according to claim 1 or 2, **characterised in that** the first material is chosen such that the first sub-layer (2) promotes the adhesion of the second sub-layer (4) and of the coloured external decorative layer (5).

4. Method according to one of the preceding claims, **characterised in that** the second material is chosen such that the colour of the second sub-layer (4) is close to the colour of the coloured external decorative layer (5).

5. Method according to one of the preceding claims, **characterised in that** the first material is chosen from the group comprising nickel, chromium, stainless steel, tin, precious metals, and alloys thereof.

6. Method according to one of the preceding claims, **characterised in that** the second material is an alloy of nickel and chromium.

7. Method according to one of claims 5 and 6, **characterised in that** the first material and/or the second material is an alloy of nickel and chromium, the quantity of chromium being comprised between 20 wt% and 80 wt%, and preferably between 30 wt% and 70 wt%.

8. Method according to one of the preceding claims, **characterised in that** the second sub-layer (4) has a thickness comprised between 200 nm and 1500 mm.

9. Method according to one of the preceding claims, **characterised in that** the third coloured material is chosen from the group comprising precious metals and alloys thereof, aluminium and alloys thereof, and ceramics.

10. Method according to claim 9, **characterised in that** the third coloured material is chosen from the group comprising gold, silver, palladium, platinum, rhodium and alloys thereof.

11. Method according to claim 10, **characterised in that** the third coloured material is a nickel free and cobalt free gold alloy containing between 75 wt% and 77.5 wt% gold, between 1.2 wt% and 1.6 wt% palladium and between 20.1 wt% and 23.8 wt% copper.

12. Method according to one of the preceding claims, **characterised in that** the coloured external decorative layer (5) has a thickness comprised between 100 nm and 1500 mm.

13. Method according to one of the preceding claims, **characterised in that** the physical vapour deposition method is a cathodic sputtering method.

14. Method according to one of the preceding claims, **characterised in that** the step of mechanically treating the timepiece component (1) of the preparation step a) is a diamond polishing step.

15. Method according to one of the preceding claims, **characterised in that** at least the second deposition step b) and the colouring step c), and the first deposition step in the preparation step a), are achieved without breaking vacuum conditions.

16. Method according to one of the preceding claims, **characterised in that** the timepiece component (1) is chosen from the group comprising hands, appliques, dials, flanges, bezels, crowns, push-pieces, oscillating weights, wheels, plates and bridges.
